Europäisches Patentamt

European Patent Office

Office européen des brevets

(11) Publication number: **0 333 513 B1**

# EUROPEAN PATENT SPECIFICATION

(45) Date of publication of patent specification: **06.10.93**  (51) Int. Cl.5: **H01L 39/12**, H01L 39/24

(21) Application number: **89302682.3**

(22) Date of filing: **17.03.89**

(54) Oxide superconductor.

(30) Priority: **17.03.88 JP 63998/88**

(43) Date of publication of application:
**20.09.89 Bulletin 89/38**

(45) Publication of the grant of the patent:
**06.10.93 Bulletin 93/40**

(84) Designated Contracting States:
**DE FR GB**

(56) References cited:
**EP-A- 0 284 062**
**EP-A- 0 299 870**

**JAPANESE JOURNAL OF APPLIED PHYSICS,
vol. 27, no. 2, February 1988, pages
L209-L210, Tokyo, JP; H. MAEDA et al.: "A
new high-Tc oxide superconductor without a
rare earth element"**

**NATURE, vol. 332, 10th March 1988, page 103,
Basingstoke, GB; "Superconducting confer-
ence yields new temperature record"**

**NATURE, vol. 332, 10th March 1988, pages
138-139, Basingstoke, GB; Z.Z. SHENG et al.:
"Bulk superconductivity at 120 K in the Tl-
Ca/Ba-Cu-O system"**

(73) Proprietor: **MATSUSHITA ELECTRIC INDUSTRI-
AL CO., LTD.**
**1006, Oaza Kadoma**
**Kadoma-shi, Osaka-fu, 571(JP)**

(72) Inventor: **Ichikawa, Yo**
**2-107-1-201 Dainichi-cho**
**Moriguchi Osaka 570(JP)**
Inventor: **Kitabatake, Makota**
**17-B-501 3-chome**
**Tomiyokita**
**Nara Nara 631(JP)**
Inventor: **Adachi, Hideaki**
**3-1-505 Miiminani-machi**
**Neyagawa Osaka 572(JP)**
Inventor: **Setsune, Kentaro**
**4-24-9 Niwashirodai**
**Sakai Osaka 590-01(JP)**
Inventor: **Wasa, Kiyotaka**
**2-7-27 Chiyogaoka**
**Nara Nara 631(JP)**

(74) Representative: **Crawford, Andrew Birkby et al**
**A.A. THORNTON & CO.**
**Northumberland House**
**303-306 High Holborn**
**London WC1V 7LE (GB)**

Rank Xerox (UK) Business Services
(3.10/3.6/3.3.1)

EP 0 333 513 B1

## Description

This invention relates to an oxide superconductor, and more particularly to a compound thin film superconductor.

As high transition temperature superconductors, hitherto, niobium nitride (NbN) and germanium niobate as A15 type two-element compounds have been known. The superconducting transition temperature of these materials was 24°K at most. On the other hand, in the perovskite type three-element compound, a much higher transition temperature is expected, and the high transition temperature superconductor of Ba-La-Cu-O compound has been proposed (J. G. Bendorz and K. A. Müller, Zeit Schrift für Physik B, Condensed Matter, 64, 189-193, 1986). More recently, it is proposed that Y-Ba-Cu-O compounds are superconductive materials of higher transition temperature (M. K. Wu, et al., Physical Review Letters, vol. 58, No. 9, 908-910, 1987).

It was further discovered that materials of Bi-Sr-Ca-Cu-O compound and Tℓ-Ba-Ca-Cu-O compound show transition temperatures of over 100°K.

The details of the superconducting mechanism of these materials are not disclosed, but it is possible that the transition temperature may be higher than the temperature of liquid nitrogen, and it is expected that more preferable charactersitics as the high transition temperature superconductors than those in the conventional materials be obtained.

These oxide materials are, however, obtained in the form of ceramic powder or blocks by sintering in the initial stage, and it was attempted to transform into thin films or wires in the application aspect. That most important factor in application is the critical current density, but in the existing ceramics, only very small values could be observed. When these oxide materials were made into thin films, the critical current was dramatically increased, but it is still insufficient. As for the controllability of increase of the critical current of thin film, nothing is elucidated at the present, and the development of the method and material of high controllability for introduction of the pinning center of the magnetic flux has been desired.

The present invention provides an oxide superconductor whose principal component is $AB_2Cu_3O_{7-\delta}$, where $\delta$ is in the range of $O \leq \delta < 7$, A is at least one of Y and lanthanum series elements excluding atomic numbers 58, 59, 61, 65, and B is barium or calcium or a combination of barium or calcium and one or more other Group IIa elements, wherein part of the oxygen is replaced at least by one of sulphur (S), selenium (Se), tellurium (Te) and polonium (Po). The critical current density is increased when S, Se, Te or Po is mixed into this kind of high transition temperature superconductive material. Furthermore it has been found that the critical current density is further considerably increased when the molar ratio of S, Se, Te or Po is in the relation of

$$O < \frac{S,\ Se,\ Te,\ Po}{O} \leq 0.01.$$

The present inventors, moreover, discovered that a high transition temperature superconductor of a thin film shape high in critical current density is formed when the thin film of this kind of material is deposited by ion processing, and, on the basis of this finding, reached the fabricating method of thin film superconductor.

In addition, for use in the fabrication of this thin film superconductor, a preferable target for sputtering has been invented. In other words, the present invention involves the fabricating method of high transition temperature superconductor having a high critical current density and its thin film, and the target for sputtering relating to this fabricating method.

Furthermore, a composite compound film containing

$$O < \frac{S,\ Se,\ Te,\ Po}{O} \leq 0.01$$

in the superconductor is deposited. In this case, A' is at least one kind of Y, lanthanum series elements excluding atomic numbers 58, 59, 61, 65, Tl and Bi, and B is one or more elements of Group IIa elements. Furthermore, the fabricating method of the thin film superconductor is intended to deposit the composite compound film on the substrate by physical vapor deposition such as sputtering deposition and vacuum deposition, or chemical vapor deposition, plasma enhanced chemical vapor deposition and photo-chemical vapor deposition. The target for sputtering of the invention related to this fabricating method is mainly composed of a mixture or compound of a first substance comprising $A'O_x$, $BO_x$, $CuO_z$ or their compounds, and a second substance composed of at least one of $A'S_w$, $A'Se_w$, $A'Te_w$, $A'Po_w$. In this case X, Y, Z and W are in relation to $O < X, Y, Z, W \leq 1$. The present inventors reached this invention by discovering that the thin film superconductor showing a high critical current density at excellent controllability and reproducibility could be formed by employing the fabricating method of thin film superconductor and the target for sputtering mentioned above as well as that the oxide superconductor and its thin film superconductor show a high critical current density.

While the novel features of the invention are set forth in the appended claims, the invention, both as to organization and content, will be better understood and appreciated, along with other objects and features thereof, from the following detailed description taken in conjunction with the drawings.

FIG. 1 is a basic structural sectional view of a thin film superconductor of the present invention;

FIG. 2 is a basic structural sectional view of a fabricating apparatus used in the fabricating method of thin film superconductor of the invention;

FIG. 3 is a diagram showing a sputtering state by using the target in one of the embodiments of the invention; and

FIG. 4 and FIG. 5 are a magnetization curve at 4.2K of $YBa_2Cu_3O_{7-\delta}$ thin film containing S in an embodiment of the invention, and a magnetization curve of $YBa_2Cu_3O_{7-\delta}$ thin film not containing S.

First of all, the present inventors prepared an oxide superconductor containing S, Se, Te or Po by sintering.

(Example 1)

The material oxide superconductor is $YBa_2Cu_3O_{7-\delta}$. In the first step, powders of $Y_2O_3$, $BaCo_3$, CuO were mixed so that the molar ratio may be Y:Ba:Cu = 1:2:3, and blended well. The mixture was put into an alumina crucible, and was sintered in air for 8 hours at 950°C. This sinter was pulverized, and pressed to a disc form of 2 mm in thickness and 10 mm in diameter. The disk form was sintered in air for 5 hours at 900°C. The change in resistance of this sinter depending on temperature was measured, and a superconducting transition was observed at 90K, and the resistance was almost zero at 85K.

The inventors investigated into a preferred form of mixing S, Se, Te, Po when mixing the powders of $Y_2O_3$, $BaCO_3$, CuO in the step of mixing S, Se, Te or Po into $YBa_2Cu_3O_{7-\delta}$ superconductor. When S, Se, Te or Po was mixed alone in powder form, the powder precipitated unevenly in the sintering step, resulting in inferior crystallinity because the melting point of these substances is generally low. Accordingly, the present inventors found that, when S, Se, Te, or Po was mixed in a form of compound with Y or Ba or Cu, they mixed uniformly with other element to result in an excellent crystallinity. It was also confirmed that the critical current density of the sinter was increased when S, Se, Te or Po was mixed as compared with when not mixed.

Furthermore, the present inventors investigated into a proper content of S, Se, Te or Po to be

mixed in $YBa_2Cu_3O_{7-\delta}$ from the aspects of crystal structural property, electrical property, mechanical property, and reproducibility, and discovered that a superconductor extremely large in critical current density, and excellent in crystal structural property, stability and reproducibility be obtained in a range of

$$0 < \frac{S, \ Se, \ Te, \ Po}{O}$$

$\leq 0.01$.

Incidentally, on the oxide superconductors of Bi-Sr-Ca-Cu-O system and Tℓ-Ba-Ca-Cu-O system, the same experiment as mentioned above was conducted, and it was confirmed that excellent oxide superconductors were obtained in a range of

$$0 < \frac{S, \ Se, \ Te, \ Po}{O} \leq 0.01.$$

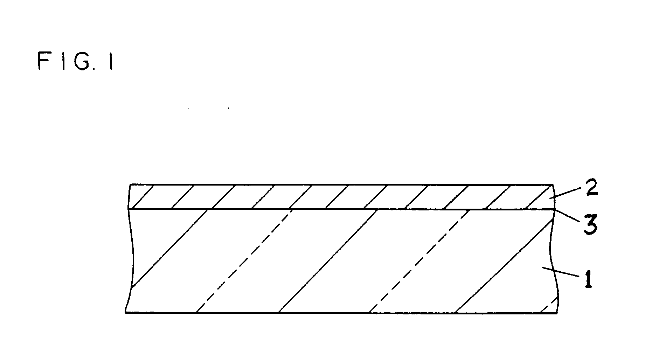

Moreover, the oxide superconductor of the invention was formed into a thin layer, and a basic structural sectional view of the thin film superconductor is explained below while referring to FIG. 1.

In FIG. 1, an oxide superconductor thin film 2 containing S, Se, Te or Po is formed, for example, by the sputtering method. In this case, a substrate is intended to support the oxide superconductor thin film 2 containing S, Se, Te or Po which shows superconductivity. Therefore, the superconductor of the invention is substantially in a layered structure. This layered structure is usually formed at a high temperature of 800 to 900°C, and a superconduction is effected at a low temperature of liquid nitrogen temperature (-195°C), and therefore the adhesion between the substrate 1 and the film 2 becomes inferior and the layered structure is often broken, which was confirmed by the present inventors. As a result of further investigation into the thermal characteristics of the substrate in various materials, it was confirmed by the inventors that the layered structure is not broken and can be used practically if the coefficient of linear thermal expansion of the substrate is in a range of $\alpha > 10^{-6}/°C$. For example, when quartz glass of $\alpha < 10^{-6}/°C$ was used as the substrate, innumerable cracks were formed in the film 2, which became a discontinuous film and could be hardly used practically, according to the experiment by the inventors.

The present inventors also discovered there is an optimum material for the substrate 1 of the layered structure in FIG. 1 from the viewpoint of function.

That is, in order to form an oxide superconductor thin film 2 containing S, Se, Te or Po high in the crystal structural property on the surface 3 of the substrate 1, a substrate of single crystal is effective. The present inventors, as a result of close investigation into optimum substrate materials, confirmed that a single crystal of magnesium oxide, sapphire ($\alpha$-$A\ell_2O_3$), spinel, strontium titanate, silicon and gallium arsenic is effective as the substrate 1. Anyway, since it is intended to form a film 2 of high crystal structural property effectively on the surface 3, the substrate surface 3 should be at least single crystal.

When processing this kind of superconductor into an arbitrary shape, for example, a cylindrical shape, it was found by the inventors that the so-called sintered ceramic is effective, rather than the single crystal, as the substrate, and adequate ceramic materials were discovered. That is, as the ceramic substrate, it was known that alumina, magnesium oxide, zirconium oxide, steatite, forsterite, beryllia and spinel are excellent in processability of the substrate and adhesion of the superconductor thin film 2 to the substrate 1. In this case, too, at least only the surface of the substrate should be made of this ceramic materials same as in the case of single crystal.

Meanwhile, when the substrate was platinum (Pt) or when the surface of the substrate was coated with Pt, a thin film superconductor having an excellent crystal structural property was obtained.

For formation of thin film superconductor, to begin with, a composite compound film composed of A', B, Cu, O and containing S, Se, Te or Po is deposited on the substrate by sputtering deposition or vacuum deposition such as electron beam deposition, laser beam deposition or other physical vapor phase growth method. In this case, as the composite compound film, only the stoichiometric ratio should be matched, such as the components Y-Ba-Cu, Er-Ba-Cu, Gd-Ba-Cu, Bi-Sr-Ca-Cu and T$\ell$-Ba-Ca-Cu, and the oxygen content is not particularly important, as confirmed by the present inventors. As a result, the forming method of the composite compound film may not be limited to physical vapor phase growth, but the chemical vapor phase growth methods such as the atmospheric or vacuum chemical vapor phase growth, plasma enhanced chemical deposition and photochemical deposition may be also effective, as far as matched properly, as confirmed by the inventors.

The present inventors have confirmed that there is a range of appropriate temperatures for the substrate 1 when depositing the composite compound film 2 on the surface 3 of the substrate 1. That is, the substrate optimum temperature range was 100 to 1000°C. Below 100°C, the adhesion of the composite oxide film on the substrate surface was poor. Over 1000°C, the component Cu in the composite oxide film is largely deviated from the stoichiometric ratio.

Incidentally, the superconductive characteristic of the compound containing S, Se, Te or Po in the composite compound of $AB_2Cu_3O_{7-\delta}$ system represented by $YBa_2CU_3O_{7-\delta}$ shows a critical temperature of over 85K in as-deposited state by forming a thin film at the substrate temperature of 600°C to 700°C. Furthermore, when this formed composite compound film was introduced, in succession to the forming process without exposing to the air, into the film forming apparatus together with gas containing at least oxygen, and the substrate temperature was set in a range of 200 to 900°C, the superconductive characteristic of the film was increased. In this case, moreover, when the content of S, Se, Te or Po was in a range of

$$0 < \frac{S, \; Se, \; Te, \; Po}{O} \leq 0.01,$$

the critical current density was extremely high, and the controllability and reproducibility of the thin film formation were excellent, as discovered by the present inventors.

The superconductive characteristic of the composite compounds of Bi, Sr, Ca, Cu, O system, and T$\ell$, Ba, Ca, Cu, O system had two phases, one with the transition temperature of 100K or less and the other over 100K, depending on the composition and fabrication conditions.

In the material of Bi, Sr, Ca, Cu, O system, when the substrate temperature was set over 600°C at the time of deposition of the composite compound film, the reproducibility to the characteristic of the composite compound film of over 100K was improved, as recognized by the present inventors.

Furthermore, in the material of T$\ell$, Ba, Ca, Cu, O system, since the vapor pressure of T$\ell$ is abnormally high, by depositing the composite compound film at the substrate temperature of 200°C or higher and 400°C or lower, and heating at 850 to 950°C in an oxygen atmosphere or an oxygen atmosphere containing at least T$\ell$ vapor, a phase with the transition temperature of over 100K was shows with an extremely excellent reproducibility, as confirmed by the present inventors.

However, the produced film may not exhibit an excellent superconducting transition characteristic as it is. In such a case, as the present inventors have discovered, a favorable superconduction was generated when this composite compound film was further heated in the air, mixed gas of argon and oxygen, nitrogen and oxygen, or oxidizing atmosphere such as pure oxygen. In this case, the optimal heat treatment temperature was 600 to 1000°C, and the heat treating time was 1 minute to 100 hours.

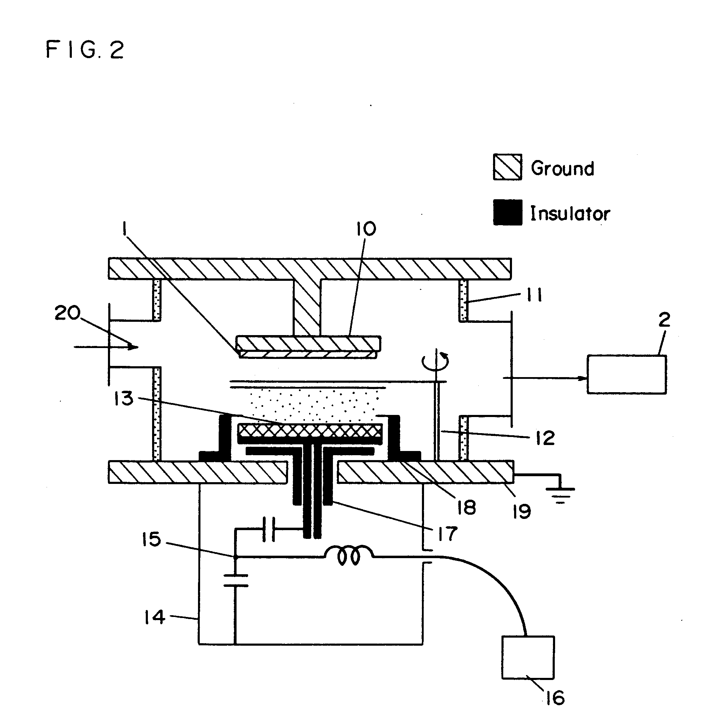

This type of superconductor thin film was applied in a sputtering apparatus. An outline of the sputtering apparatus is shown in FIG. 2.

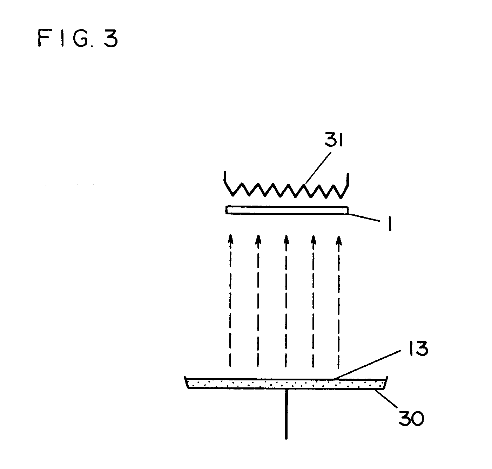

As the sputtering target 13 shown in FIG. 2 for example, a mixture or compound comprising a first substrate composed of $A'O_X$, $BO_Y$, $CUO_Z$ or their compound, and a second substance composed of at least one of $A'S_W$, $A'Se_W$, $A'Te_W$, $A'Po_W$ may be used. Here, $0 < X, Y, Z, W \leq 1$, and $A'$ is at least one of Y, lanthanum series elements (excluding atomic numbers 58, 59, 61, 65), and Bi or $T\ell$, and B is at least one of the IIa group elements. In this case, as the target composition, a sintered body such as disc and cylinder is useful. But it is not always required to be a formed piece, and as shown in FIG. 3 it is all right if in powder, granular or chuck form as far as the constituent metal element ratio of the target satisfies the above requirements of $AB_2Cu_3O_{7-\delta}$, Bi-Sr-Ca-Cu-O, or $T\ell$-Ba-Ca-Cu-O. In particular, when a container 30 is filled with powder or granular target 13, the target 13 can be used in a desired shape, and the composition ratio when preparing the superconductor film can be optimized, which is extremely advantageous. Numeral 31 denotes a heater. The superconductive material which tends to be uneven in the composition when sintered can easily realize a uniform target, and the powder and granular target has been confirmed to be very effective. Meanwhile, since the constituent elements of the target are evaporated in atom forms when sputtered, the target may not be always the sintered compound of $AB_2Cu_3O_{7-\delta}$, Bi-Sr-Ca-Cu-O, or $T\ell$-Ba-Ca-Cu-O. If a compound of constituent metal element of the target, for example, $A'O_X$, $BO_Y$, $CuO_Z$, is mixed in, since these metal elements $A'$, B, Cu are sputtered in the atomic form, it is enough as far as the metal element concentrations depositing on the substrate satisfy the requirements of $AB_2Cu_3O_{7-\delta}$, Bi-Sr-Ca-Cu-O, or $T\ell$-Ba-Ca-Cu-O, in which X, Y, Z > 0.

It was confirmed here that S, Se, Te or Po is effective as the target when mixed as the compound with $A'$ element, such as $A'S_W$, $A'Se_W$, $A'Te_W$, $A'Po_W$. This is because S, Se, Te, Po are substances of high vapor pressure, and the compound with B or Cu is also high in vapor pressure. In other words, when a substance with a high vapor pressure is contained in the target, the reproducibility and uniformity of the formed film are sacrificed. Since $A'S_W$, $A'Se_W$, $A'Te_W$, and $A'Po_W$ are lower in vapor pressure than them, a film is formed at excellent reproducibility and uniformity, and the mixing ratio of

$$0 < \frac{S, Se, Te, Po}{O} \leq 0.01$$

is realized, in which W > 0.

Incidentally, the target may not be of single composition, but if the target is composed of dissimilar composition, such as $A'O_X$, $BO_Y$, $CuO_Z$, $A'S_W$, $A'Se_W$, $A'Te_W$, $A'Po_W$, or their compounds, it is enough as far as the total metal element concentrations depositing on the substrate satisfy the requirements of $AB_2Cu_3O_{7-\delta}$, Bi-Sr-Ca-Cu-O, or $T\ell$-Ba-Ca-Cu-O.

It was also effective when $A'F_X'$, $BF_Y'$, $CuF_Z'$ were contained. In particular, $BF_Y'$ was low in the impurity concentration as compared with $BO_Y$, and it was particularly effective because a reagent of high purity could be obtained.

Meanwhile, by employing the multiple sputtering, when the constituent elements to compose the plural targets were $AO_X$, $BO_Y$, $CuO_Z$ and they were sputtered at the same time, it is enough when the metal element concentrations depositing on the substrate satisfy the requirements of $AB_2Cu_3O_{7-\delta}$, Bi-Sr-Ca-Cu-O, or $T\ell$-Ba-Ca-Cu-O.

Here, if the target contained Li or Li compound, an improvement was noted in the stability of characteristics and the reproducibility of the obtained superconductive film.

In particular, the powder or granular target of the invention does not require forming and can be supplied continuously while sputtering, and it is very effective for fabrication of this type of superconductor.

The invention is illustrated below in a practical example.

(Example 2)

Using the magnesium oxide single crystal (100) plane as the substrate 1, the compound target in the composition of $Y_{1.07}Ba_2Cu_{4.5}O_8S_{0.1}$ sintered together with YS was sputtered in a mixed gas atmosphere of $Ar + O_2$, and a film of $YBa_2Cu_3O_7$ containing crystalline S by $\frac{S}{O}$ = approx. 0.0075 was deposited on the substrate kept at 650°C, thereby forming a layered structure.

In this case, the Ar gas pressure was 0.5 Pa, the sputtering energy was 140 W, the sputtering time was 1 hour, the film thickness was 0.6 $\mu$m, and the substrate temperature was 650°C.

This thin film was a superconductor showing the temperature of zero resistance in as-deposited state (zero resistance temperature) of 80K.

In this example, the thickness of the film 2 was 0.6 $\mu$m, but when the thickness was 0.1 $\mu$m or less, or 10 $\mu$m or more, it was also confirmed that the superconduction occurred.

The $YBa_2Cu_3O_{7-\delta}$ film containing S formed in this condition was increased in the critical current density as compared with the film not containing S. That is, the magnetic susceptibility of the

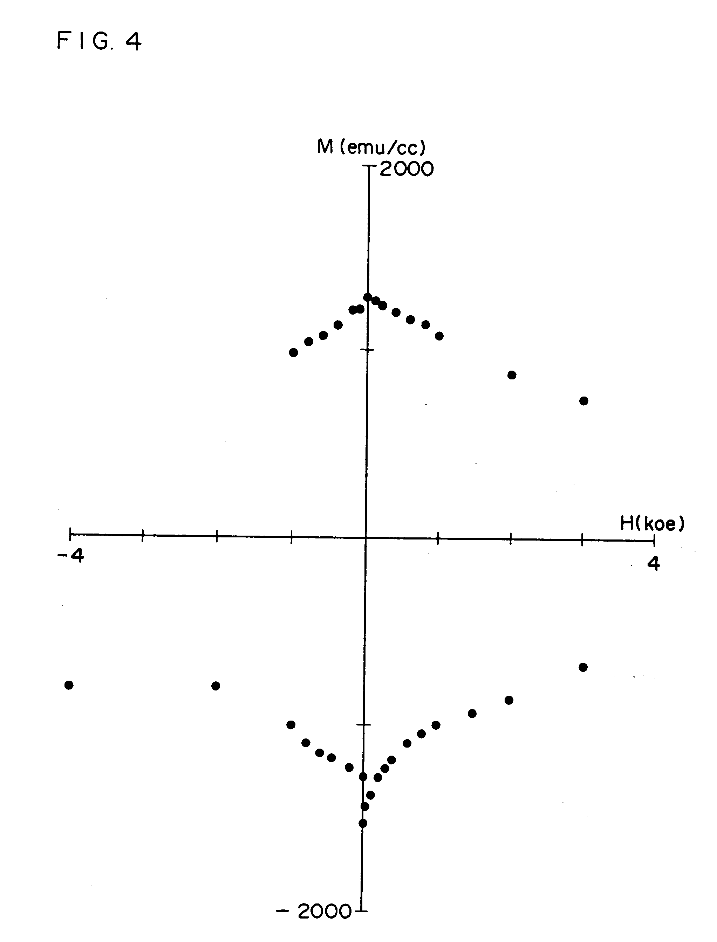

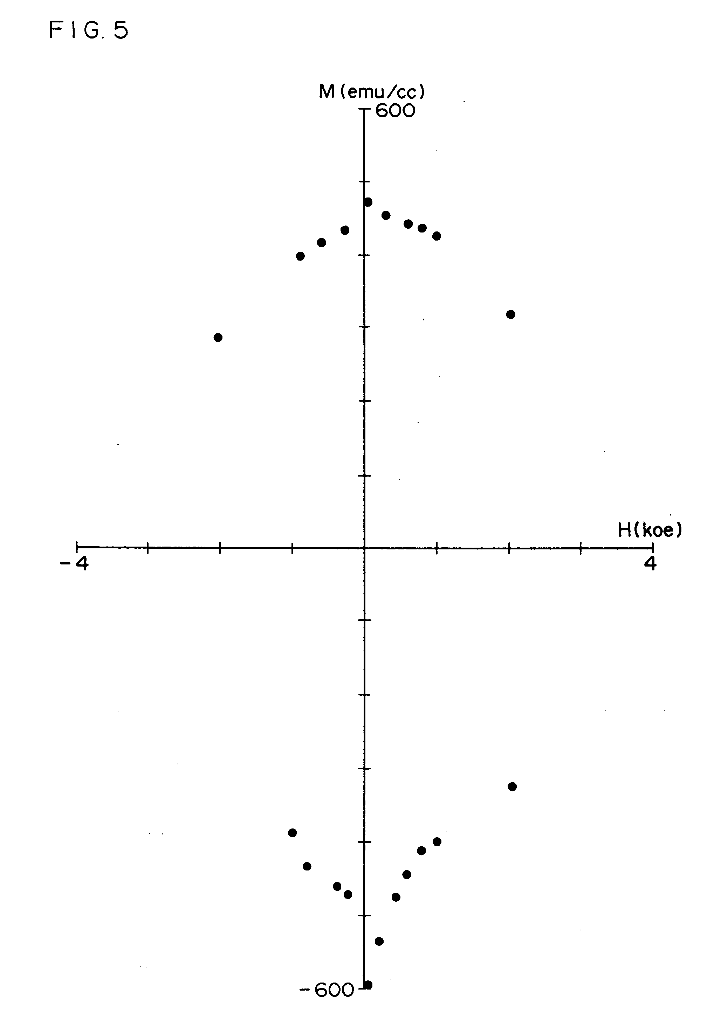

$YBa_2Cu_3O_{7-\delta}$ not containing S is shown in FIG. 5, and the result at 4.2K of the $YBa_2Cu_3O_{7-\delta}$ containing S $(\frac{S}{O} \doteq 0.0075)$ is shown in FIG. 4. Evidently, when S was contained, the magnetic susceptibility was about three times as large as that of the film without S, and the increase of the critical current density was confirmed. When S was contianed in a range of $\frac{S}{O} > 0.01$, the superconductive characteristic was extremely lowered, and the zero resistance temperature which was about 80K when S was not contained became less than 40K. In a range of $0 < \frac{S}{O} \leq 0.01$, there was almost no drop of the zero resistance temperature, and the critical current density was increased. In this experiment, the content of S was measured by EPMA (electron probe X-ray microanalysis) or ICP (inductive coupled plasma emission spectrometry). Similar effects were obtained when Se, Te or Po was contained.

In the next step, the present inventors experimentally investigated the effectiveness of crystalline substrate other than magnesium oxide. On a sapphire or spinel single crystal substrate, a thin film of $YBa_2Cu_3O_7$ structure (A = Y, B = Ba) was deposited by the sputtering method, same as in the case of magnesium oxide single crystal. Aside from these substrates, silicon and gallium arsenic single crystals coated with strontium titanate or Pt were investigated, and similar crystal structural properties were obtained. In all these cases, the superconductivity was confirmed.

In the sputtering deposition of the oxide film of this sort, a mixed gas of, for example, Ar and $O_2$ is used as the aputtering gas. Besides, the inventors also acknowledged that inert gases such as Ar, Xe, Ne, Kr, or mixed gases with these inert gases or oxygen were also effective as sputtering gas.

As the sputtering method, all of the ratio frequency diode discharge sputtering, DC diode discharge sputtering and magnetron sputtering were found to be effective. Especially in the case of DC diode discharge sputtering, the resistivity of the sputtering target must be set lower than $10^{-3}$ ohm-cm, and at a higher resistivity, sufficient sputtering discharge is not generated. The resistivity of the target can be adjusted by the sintering condition of the target.

Incidentally, as the forming method of the composite oxide film on the substrate surface, it may be also possible to deposit the metal principal components on the substrate by the sputtering deposition, emit oxygen beam or oxygen ions to the film while forming the film, and oxidize the metal principal components on the substrate surface.

The crystal structure and other specific characteristics of this kind of film involve large strains and defects in the film which do not exist in the ordinary sinter because the film is confined on the substrate. Therefore, the fabricating method of the film cannot be estimated from the properties of the film.

Similar excellent superconductive characteristics were obtained when a thin film was formed on a susbtrate kept at 400°C, and was heated for 2 hours at 850°C in an oxygen atmosphere. In this case, too, the effect of containing S, Se, Te or Po was same as mentioned above.

The physical meaning of the heat treatment of film is not known in details, but may be estimated as follows. That is, in the composite oxide film depositing on the substrate by sputtering, the substitution of trivalent element B for divalent element A is not perfect, and a compound $AB_2Cu_3O_7$ is not formed. In this case, for example, a composite oxide having an oxide of element B dispersed is formed in the network in the $ACu_3O_7$ structure.Of course, the Cu atom is divalent. The superconductive characteristic is not obtained at high reproducibility. The superconduction is derived from the replacement of element A by element B and the subsequent generation of trivalent Cu atom by oxidation of the divalent Cu atom, and this process is related to the heat treatment.

Details are not known about the change in the superconductive characteristic due to change of constituent elements A and B of the $AB_2Cu_3O_7$, containing S, Se, Te or Po of the compound superconductor of this type. It is, however, at least clear that A is divalent, B trivalent, with part of element A replaced by element B. As an example of element A, Y is explained, but when lanthanum series elements excluding atomic numbers 58, 59, 61, 65 should be used, only the superconducting transition temperature may vary, and the intrinsic characteristics of the layered structure of the invention will not be changed.

As for element B, meanwhile, changes in Sr, Ca, BaSr, Ca, Ba and other IIa group element may cause to change the superconducting transition temperature by about 10 K, but the intrinsic characteristics of the layered structure of the invention will not be changed.

(Example 3)

Using the magnesium oxide single crystal (100) plane as the substrate 1, Bi-Sr-Ca-Cu-O and Bi-S were sintered by the radio frequency planar magnetron sputtering, and the target made of their mixture or compound was used to sputter in the mixed gas atmosphere of Ar and oxygen, and a layered structure was formed by depositing the Bi-Sr-Ca-Cu-O film containing crystalline S on the substrate.

In this case, the mixed gas pressure of Ar and oxygen was 0.5 Pa, the sputtering energy was 150 W, the sputtering time was 1 hour, the thickness of the film was 0.5 $\mu$m, and the substrate temperature was 700°C. The formed film kept at 700°C was annealed for 1 hour in the forming apparatus by introducing gas containing oxygen in succession. Besides, the similarly formed film was taken out of the apparatus, and was heated in the air for 1 hour at 880°C, and was cooled gradually for 3 hours.

In this example, the thickness of the film was 0.5 $\mu$m, but when the thickness was 0.1 $\mu$m or less or 10 $\mu$m or more, it was confirmed that superconductivity occurred.

When the content of S in this film was in a range of $0 < \frac{S}{O} \leq 0.01$, an increase in the critical current density was noted same as in the case of Y-Ba-Cu-O, and when $\frac{S}{O} > 1\ 0.01$, the superconductive characteristics deteriorated. The same effects were obtained with Se, Te and Po.

The present inventors closely examined exprimentally the effectiveness of the crystalline substrate other than magnesium oxide. On the spinel single crystal substrate, films of Bi, Sr, Ca, Cu, O system containing S, Se, Te or Po were deposited by the sputtering method same as in the case of magnesium oxide single crystal, and when these films were heated in the air for 1 hour at 880°C and cooled gradually for 3 hours, the superconductivity was observed in all of them. In addition, similar effects were obtained in the single crystals of strontium titanate, silicon and gallium arsenic.

The structures of superconductive materials of Bi, Sr, Ca, Cu O are complicated and are not known yet. In the single crystal substrate, when the substrate temperature is raised over the epitaxial temperature, the intended crystal phase may not be obtained depending on the conditions of fabrication. Therefore, the present inventors experimentally confirmed that the superconductive characteristics would be obtained at high reproducibility when the substrate temperature was selected rather in a low range and crystallization was effected by heat treatment after forming a composite compound film in amorphous or fine crystalline structure.

In this case, the substrate in single crystal structure is effective because it supports the solid phase epitaxial growth of the film in the heat treatment process. In particular, by preliminarily forming an amorphous film on the substrate and heating it, and by properly selecting the substrate single crystal material, it was found that a crystalline film was developed effectively on the crystalline substrate surface in solid phase epitaxial growth, which is effective for forming a thin film excellent in superconductive characteristics. Meanwhile, if the crystal structural property of the superconductive film is not particularly required (when the steep superconductive transition is not needed), the polycrystalline ceramic substrate is effective.

In sputtering deposition of this type of oxide film, a mixed gas of, for example, Ar and $O_2$ is used as the sputtering gas. Besides, experimentally, inert gases such as Ar, Xe, Ne and Kr, and mixed gases with such inert gases were also confirmed to be effective as sputtering gas.

As the sputtering method, the diode discharge sputtering, radio frequency diode discharge sputtering, DC diode discharge sputtering and magnetron sputtering have been also confirmed to be effective. Especially in the case of DC diode discharge sputtering, it is necessary to set the resistivity of the sputtering target below $10^{-3}$ ohm-cm, and at a higher resistivity, sufficient sputtering discharge is not generated. The resistivity of the target can be adjusted usually by the sintering condition of the target.

In this type of apparatus, in particular, the DC sputtering is effective for precision control of the sputter energy and others, and the DC magnetron sputtering or DC magnetron sputtering gun has been recognized to be particularly effective.

As the method for forming a composite compound film on the substrate surface, it is also possible to deposit the metal principal components on the substrate by the physical vapor phase growth method, emit oxygen beam or oxygen ions to the film while forming the film, and oxidize the metal principal components on the substrate surface. As the method physical vapor phase growth, aside from the sputtering, thermal deposition may be applied, in which while emitting electron beam, sputtering is effected by using the alloy principal components of the composite oxide film as the target. In this case, the film forming speed was one digit faster than the sputtering deposition by using the composite oxide as target, which is more effective industrially.

The specific characteristics of the film of this sort such as crystal structure involve large strains and defects in the film which are not found in the ordinary sinter because the film is confined on the substrate. Therefore, the fabricating method of the film may not be estimated from the fabricating method of the sinter. Meanwhile, the physical meaning of the heat treatment of the film is not known in details, but it may be approximately considered as follows. That is, in the composite compound film deposited on the substrate by sputtering, the compound of Bi-Sr-Ca-Cu-O containing S, Se, Te or Po is not formed. In this case, for example, a composite oxide having an oxide of element A dispersed is formed in the network of the perovskite structure of tetragonal system of, for example, (Sr, Ca)CuO$_3$. The superconduction is derived from the occurrence of layered perovskite structure, and this process is related to the heat treatment. Meanwhile, that the superconductivity was not obtained by the heat treatment of less than 1 was considered because the formation of the crystal phase at transition temperature of 100K or more was insufficient. The heat treatment was conducted in an ordinary heater furnace, but other heating method is also possible, such as industrial heating method by laser beam or infrared ray, or heating by electron rays.

Details are not known about the change in the superconductive characteristics due to changes in constituent elements Bi, Sr and Ca of the Bi-Sr-Ca-Cu-O containing S, Se, Te or Po in the compound superconductor of this sort. It is, however, at least clear that B is trivalent, and S, Ca divalent.

(Example 4)

Using magnesium oxide monocrystal (100) plane as the substrate 1, the target of mixture or compound of Tℓ-Ba-Ca-Cu-O and Tℓ-S sintered by the radio frequency planar magnetron sputtering was subjected to sputtering deposition in a mixed gas atmosphere of Ar and oxygen, and a Tℓ-Ba-Ca-Cu-O film containing S was deposited on the substrate.

In this case, the mixed gas pressure of Ar and oxygen was 0.5 Pa, the sputtering energy was 120 W, the sputtering time was 1 hour, the thickness of film was 0.5 $\mu$m, and the substrate temperature was 200°C. Incidentally, Tℓ is abnormally high in the vapor pressure, and evaporation of Tℓ from the target occurs in high sputtering energy, which leads to unstable discharge and uneven evaporation film. The present inventors discovered that a uniform evaporation film could be obtained by stable discharge when the sputtering energy was 50 W or more and 120 W or less. At a higher substrate temperature, Tℓ is not evaporated on the substrate, and it was hence found necessary to control the substrate temperature under 400°C.

The formed film was amorphous, and heat treatment was applied in order to superconductive characteristics. When heated in oxygen atmosphere or in the air, it was found that Tℓ was completely dissociated from the film at the heat treatment temperature of 700°C or over. Accordingly the inventors could obtain superconductive characteristics by heating in an oxygen atmosphere containing Tℓ gas. It was also known that a superconducting transition temperature of 100K or more could be obtained by the heat treatment at 850°C to 950°C, for 1 to 60 minutes.

In this example, the thickness of film was 0.5 $\mu$m, but it was also confirmed that superconduction occurred even if the thickness of the film was 0.1 $\mu$m or less or 10 $\mu$m or more.

When the content of S in this film was in a range of $0 < \frac{S}{O} \leq 0.01$, the critical current density increased same as in the case of Y-Ba-Cu-O. If $\frac{S}{O} > 0.1$, the superconductivity deteriorated. The same effects were obtained with Se, Te or Po.

Furthermore, as a result of study on the effectiveness of other crystalline substrates than magnesium oxide, there was no difference from Bi-Sr-Ca-Cu-O. It is considered as the reason that the ion radius and the crystal structure to induce superconductivity be similar although Bi and Tℓ, Sr and Ca are added to Bi-Sr-Ca-Cu-O and Tℓ-Ba-Ca-Cu-O. In other substrates, too, the characteristics were almost similar to those of Bi-Sr-Ca-Cu-O.

In the foregoing embodiments, the films were formed by sputtering method, but this invention is also effective in thin films formed by other methods. Moreover, aside from the thin film, the effect of containing S, Se, Te or Po to increase the critical current density is similar in the bulk or wire materials. As for the materials, too, aside from 1-, 2-, 3-element compounds represented by YBa$_2$Cu$_3$O$_{7-\delta}$, Bi-Sr-Ca-Cu-O compounds and Tℓ-Ba-Ca-Cu-O compounds mentioned above, the invention is equally effective to other oxide superconductors.

In the examples disclosed so far, in order to obtain oxide superconductors, it was found that heat treatment at about 900°C should be necessary, and in order to obtain oxide superconductor thin films, the substrate temperature of 600°C or similar heat treatment should be necessary. Considering the aspect of application of these materials, since interaction with other materials is expected, it is desired to form at a low temperature as far as possible. Therefore, by adding various materials to this sort of material, and the temperature for obtaining superconductive characteristics was studied, and as a result it was found that the superconductor forming temperature would be lowered if lead (Pb) was added. In particular, when the Pb content was in a range of

$$0 < \frac{Pb}{Bi, \, Tℓ} \leq 0.3,$$

oxide superconductors and oxide superconductor thin film possessing extremely excellent crystal structure could be formed at a temperature about 100°C lower than the ordinary forming temperature of oxide superconductor thin films.

**Claims**

1. An oxide superconductor whose principal component is AB$_2$Cu$_3$O$_{7-\delta}$, where $\delta$ is in the range of $0 \leq \delta < 7$, A is at least one of Y and lanthanum series elements excluding atomic numbers 58, 59, 61, 65, and B is barium or calcium or a combination of barium or calcium and one or more other Group IIa elements, wherein part of the oxygen (O) is replaced at least by one of sulphur (S), selenium (Se), tellurium (Te) and polonium (Po).

2. An oxide superconductor whose principal component is Bi-Sr-Ca-Cu-O, wherein part of the oxygen is replaced at least by one of sulphur (S), selenium (Se), tellurium (Te) and polonium (Po).

3. An oxide superconductor whose principal component is Tl-Ba-Ca-Cu-O, wherein part of the oxygen is replaced at least by one of sulphur (S), selenium (Se), tellurium (Te) and polonium (Po).

4. An oxide superconductor according to claims 1, 2 or 3, wherein the molar ratio of S, Se, Te or Po is contained in the following range with respect to O.

$$0 < \frac{S, \ Se, \ Te, \ Po}{O} \le 0.01$$

5. An oxide superconductor of claim 2, wherein Pb is further added.

6. An oxide superconductor of claim 3, wherein Pb is further added.

7. An oxide superconductor according to claims 1, 2 or 3, wherein Li or Li compound is contained.

8. A thin film superconductor having a composite compound film mainly composed of A', B, Cu, O and containing S, Se, Te or Po with a molar ratio in a range of

$$0 < \frac{S, \ Se, \ Te, \ Po}{O} \le 0.01$$

deposited on a substrate, where A' is at least one of Y, lanthanum series elements excluding atomic numbers 58, 59, 61, 65, Tl and Bi, and B is barium or calcium or a combination of barium or calcium and one or more other Group IIa elements.

9. A thin film superconductor of claim 8, wherein Li or Li compound is contained.

10. A thin film superconductor of claim 8, wherein the substrate is made of Pt or coated with Pt film.

11. A target for sputtering composed of mixture or compound of a first substance comprising $A'O_X$, $BO_Y$, $CuO_Z$ or their compounds, and a second substance made of at least one of $A'S_W$, $A'Se_W$, $A'Te_W$, $A'Po_W$, where W, X, Y, Z > O, A' is at least one of Y, lanthanum series elements excluding atomic numbers 58, 59, 61, 65, Tl and Bi, and B is barium or calcium or a combination of barium or calcium and one or more other Group IIa elements.

12. A target for sputtering of claim 11, wherein the first substance is composed of mixture or compound of $A'O_X$, $BO_Y$, $CuO_Z$, and $A'F_{X'}$, $BF_{Y'}$, $CuF_{Z'}$, where X', Y', Z' > O.

13. A target for sputtering of claim 11, wherein the first substance, second substance, and Li or Li compound are contained.

**Patentansprüche**

1. Ein Oxid-Supraleiter, dessen Hauptbestandteil $AB_2Cu_3O_{7-\delta}$ ist, wo $\delta$ im Bereich von $0 \le \delta < 7$ ist, A wenigstens eines von Y und von Elementen der Lanthanreihe unter Ausschluß der Atomzahlen 58, 59, 61, 65 ist und B Barium oder Kalzium oder eine Kombination von Barium oder Kalzium und eines oder mehrere andere Elemente der Gruppe IIa ist, worin ein Teil des Sauerstoffs durch wenigstens eines von Schwefel (S), Selen (Se), Tellurium (Te) und Polonium (Po) ersetzt ist.

2. Ein Oxid-Supraleiter, dessen Hauptkomponente Bi-Sr-Ca-Cu-O ist, worin Teil des Sauerstoffes durch wenigstens eines von Schwefel (S), Selen (Se), Tellur (Te) und Polonium (Po) ersetzt ist.

3. Ein Oxid-Supraleiter, dessen Hauptbestandteil Tl-Ba-Ca-Cu-O ist, worin Teil des Sauerstoffes durch wenigstens eines von Schwefel (S), Selen (Se), Tellur (Te) und Polonium (Po) ersetzt ist.

4. Ein Oxid-Supraleiter gemäß Anspruch 1, 2 oder 3, in dem das Molverhältnis von S, Se, Te oder Po in dem folgenden Bereich in bezug auf O enthalten ist

$$0 < \frac{S, \; Se, \; Te, \; Po}{O} \leq 0,01$$

5. Ein Oxid-Supraleiter des Anspruches 2, bei dem ferner Pb hinzugefügt ist.

6. Ein Oxid-Supraleiter des Anspruches 3, bei dem ferner Pb hinzugefügt ist.

7. Ein Oxid-Supraleiter gemäß den Ansprüchen 1, 2 oder 3, wobei Li oder eine Li-Verbindung enthalten ist.

8. Ein Dünnschicht-Supraleiter mit einer zusammengesetzten Verbindungsschicht, die hauptsächlich aus A', B, Cu, O zusammengesetzt ist und S, Se, Te oder Po mit einem Molverhältnis im Bereich von

$$0 < \frac{S, \; Se, \; Te, \; Po}{O} \leq 0,01$$

enthält und auf einem Substrat abgeschieden ist, wo A' wenigstens eines von Y, von einem Element der Lanthanreihe mit Ausschluß der Atomzahlen 58, 59, 61, 65, Tl und Bi ist, und B Barium oder Kalzium oder eine Kombination von Barium oder Kalzium und eines oder mehrere andere Elemente der Gruppe IIa ist.

9. Ein Dünnschicht-Supraleiter des Anspruches 8, in dem Li oder eine Li-Verbindung enthalten ist.

10. Ein Dünnschicht-Supraleiter des Anspruches 8, bei dem das Substrat aus Pt hergestellt oder mit einer Pt-Schicht beschichtet ist.

11. Ein Zerstäubungs-Target, das aus einer Mischung oder Verbindung eines ersten Stoffes, der A'O$_X$, BO$_y$, CuO$_z$ oder ihre Verbindungen umfaßt, und einem zweiten Stoff zusammengesetzt ist, der aus wenigstens einem von A'S$_w$, A'Se$_w$, A'Te$_w$, A'Po$_w$ gemacht ist, wobei W, X, Y, Z > O sind, A' wenigstens eines von Y, von den Elementen der Lanthanreihe unter Ausschluß der Atomzahlen 58, 59, 61, 65, Tl und Bi ist, und B Barium oder Kalzium oder eine Kombination von Barium oder Kalzium mit einem oder mehreren anderen Elementen der Gruppe IIa ist.

12. Ein Zerstäubungs-Target des Anspruches 11, wobei der erste Stoff aus einer Mischung oder Verbindung von A'O$_X$, BO$_Y$, CuO$_Z$, und A'F$_X$', BF$_Y$', CuF$_Z$' zusammengesetzt ist, worin X', Y', Z' > 0 sind.

13. Ein Zerstäubungs-Target des Anspruches 11, bei dem der erste Stoff, der zweite Stoff und Li oder eine Li-Verbindung enthalten sind.

**Revendications**

1. Supraconducteur à base d'oxyde dont l'ingrédient principal est AB$_2$Cu$_3$O$_{7-\delta}$, $\delta$ étant compris dans la plage $0 \leq \delta < 7$, A étant au moins un élément choisi parmi Y et les éléments de la série du lanthane, à l'exclusion des éléments de numéro atomique 58, 59, 61 et 65, et B désigne le baryum ou le calcium ou une combinaison de baryum ou de calcium avec un ou plusieurs autres éléments du groupe IIa, et dans lequel une partie de l'oxygène (O) est remplacée au moins par un élément choisi parmi le soufre (S), le sélénium (Se), le tellure (Te) et le polonium (Po).

2. Supraconducteur à base d'oxyde dont l'ingrédient principal est Bi-Sr-Ca-Cu-O, dans lequel une partie de l'oxygène est remplacée par au moins un élément choisi parmi le soufre (S), le sélénium (Se), le tellure (Te) et le polonium (Po).

3. Supraconducteur à base d'oxyde dont l'ingrédient principal est Tl-Ba-Ca-Cu-O, dans lequel une partie de l'oxygène est remplacée par au moins un élément choisi parmi le soufre (S), le sélénium (Se), le tellure (Te) et le polonium (Po).

4. Supraconducteur à base d'oxyde selon la revendication 1, 2 ou 3, dans lequel le rapport molaire de S, Se, Te ou Po est contenu dans la plage suivante, par rapport à O (oxygène)

$$0 < (S, \; Se, \; Te, \; Po)/O \leq 0,01$$

5. Supraconducteur à base d'oxyde selon la revendication 2, dans lequel Pb est ajouté en plus.

6. Supraconducteur à base d'oxyde selon la revendication 3, dans lequel Pb est ajouté en plus.

7. Supraconducteur à base d'oxyde selon la revendication 1, 2 ou 3, dans lequel Li ou un composé de Li est incorporé.

8. Supraconducteur à couche mince ayant un film composite formé d'un composé essentiellement constitué de A', B, Cu, O et contenant S, Se, Te ou Po avec un rapport molaire compris dans la plage suivante

0 < (S, Se, Te, Po)/O ≤ 0,01

déposé sur un substrat, A' étant au moins Y, un élément de la série du lanthane, à l'exclusion des éléments de numéro atomique 58, 59, 61 et 65, Tl et Bi, et a désigne le baryum ou le calcium ou une combinaison du baryum ou du calcium et d'un ou plusieurs autres éléments du groupe IIa.

9. Supraconducteur à couche mince selon la revendication 8, dans lequel Li ou un composé de Li est incorporé.

10. Supraconducteur à couche mince selon la revendication 8, dans lequel le substrat est formé de Pt ou est revêtu d'un film de Pt.

11. Cible de pulvérisation composée d'un mélange ou d'un composé d'une première substance contenant $A'O_X$, $BO_Y$, $CuO_Z$ ou leurs composés, et une seconde substance formée d'au moins $A'S_W$, $A'Se_W$, $A'Te_W$, $A'Po_W$, W, X, Y et Z étant supérieurs à 0, A' est au moins un élément choisi parmi Y, les éléments de la série du lanthane à l'exclusion des éléments de numéro atomique 58, 59, 61 et 65, Tl et Bi, et B est le baryum ou le calcium ou une combinaison du baryum ou du calcium et d'un ou plusieurs autres éléments du groupe IIa.

12. Cible de pulvérisation selon la revendication 11, dans laquelle la première substance est composée d'un mélange ou d'un composé de $A'O_X$, $BO_Y$, $CuO_Z$ et $A'F_{X'}$, $BA_{Y'}$, $CuF_{Z'}$, X', Y' et Z' étant supérieurs à 0.

13. Cible de pulvérisation selon la revendication 11, dans laquelle la première substance, la seconde substance et Li ou un composé de Li sont incorporés.

F I G. I

FIG. 2

F I G. 3

FIG. 4

FIG. 5